# EUROPEAN PATENT SPECIFICATION

(11) **EP 4 433 870 B1**
(45) Date of publication and mention of the grant of the patent: **26.11.2025**
(21) Application number: 22802264.6
(22) Date of filing: 28.10.2022
(51) Int. Cl.: C09D 133/12, C08F 220/14, G03F 7/00, G03F 7/004, G03F 7/038, G03F 7/075, G03F 7/027, B82Y 40/00

(54) **METHACRYLATE COPOLYMER AND METHODS OF MAKING AND USING THE SAME**
METHACRYLAT-COPOLYMER UND VERFAHREN ZUR HERSTELLUNG UND VERWENDUNG DESSELBEN
COPOLYMÈRE DE MÉTHACRYLATE ET MÉTHODES DE FABRICATION ET D'UTILISATION DE CELUI-CI

(30) Priority: 16.11.2021 US 202163279716 P
(43) Date of publication of application: 25.09.2024
(73) Proprietor: 3M Innovative Properties Company, Saint Paul, Minnesota 55133-3427 (US)
(72) Inventor: ARMSTRONG, Paul B., Saint Paul, Minnesota 55133-3427 (US); ZHU, James, Saint Paul, Minnesota 55133-3427 (US); HUNT, Lucas J., Saint Paul, Minnesota 55133-3427 (US); LEONE, Amanda K., Saint Paul, Minnesota 55133-3427 (US); MAHONEY, Wayne S., Saint Paul, Minnesota 55133-3427 (US); SONNIER, Ashley R., Saint Paul, Minnesota 55133-3427 (US)
(74) Representative: Mathys & Squire
(86) International application number: PCT/IB2022/060392
(87) International publication number: WO 2023/089426

(56) References cited:
- WO-A1-2021/101944
- CN-A- 111 205 387
- US-A1- 2013 209 755
- US-A1- 2017 037 171
- US-A1- 2021 017 199

## Description

### TECHNICAL FIELD

A methacrylate copolymer is discussed along with a method of making the polymer using a reversible addition-fragmentation polymerization (RAFT) agent. In one embodiment, these methacrylate copolymers can be used for imprint lithography and/or transfer lithography.

### BACKGROUND

Lithographic techniques have been widely investigated as alternatives to conventional photolithography for high-resolution patterning of small-scaled features. Imprint or transfer lithography techniques generally use a template containing topography to replicate a surface relief on a substrate. These templates may then be used to generate tooling, such as a patterned roll, which can replicate the small-scaled features into commodity resins in a web-type format, resulting in high throughput and/or reduced cost. US 2017/037171 A1 discloses a statistical poly(PEGMA-co-BzMA-co-HFACHOH) copolymer prepared by RAFT polymerisation with 4-cyano-4-[(dodecylsufanylthiocarbonyl)sulfanyl]pentanoic acid as a RAFT agent, a photolithographic topcoat layer containing said copolymer, a layered article comprising the topcoat layer, and a method of forming an electronic device wherein the method utilizes the topcoat layer. US 2013/209755 A1 discloses a polymer composition, comprising a random copolymer of methyl methacrylate and trifluoro ethyl methacrylate or methyl methacrylate and dodecafluoroheptyl methacrylate and a method of forming a nanoscale pattern, comprising disposing a block copolymer comprising a siloxane-containing block and a non-siloxane containing block, on a surface of a substrate having the random copolymer disposed thereon.

### SUMMARY

There is a desire to identify novel polymers which can allow for high-resolution patterning of small (for example nanometer) features.

In one aspect, a polymer is described. The polymer is derived from:
(a) a (meth)acrylate monomer comprising a second terminal olefin group;
(b) an alkyl methacrylate monomer wherein the alkyl group comprises 1 to 4 carbon atoms;
(c) a mono(meth)acrylate monomer comprising a low-surface-energy group, wherein the low-surface-energy group comprises a perfluorinated alkyl group, a perfluorinated polyether group, or a silicone group; and
(d) a RAFT agent.

In another aspect, a polymer according to the following formula is described: 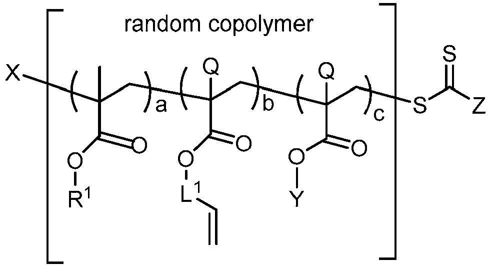 wherein:
R¹ is C1-C4 alkyl group;
L¹ is a linking group comprising 1-9 carbon atoms;
Y comprises a low-surface-energy group selected from -L²-R² or -L³-R³ wherein L² is a linking group comprising 1-9 carbon atoms and optionally at least one catenated ether, R² comprises a silicone group, L³ is a linking group comprising at least one of an ether, ester, amide, or sulfonamide and R³ comprises a perfluorinated alkyl group, or a perfluorinated polyether group;
each Q is independently selected from H or CH₃;
X comprises -C(CH₃)₂CN, -C(CH₃)₂C₆H₅, -CH(CN)C₆H₅, or -C(CH₃)₂C(=O)OC₂H₅;
Z is -C₆H₅, -SR⁵ where R⁵ is an alkyl group comprising 1-12 carbon atoms, or a monovalent pyrrole;
a is an integer from 50 to 1000;
b is an integer from 5 to 200; and
c is an integer from 1 to 50.

In yet another aspect, a liquid composition is described comprising at least one of the methacrylate copolymers described above along with a crosslinking agent; a solvent; optionally a photoinitiator; and optionally a stabilizer.

In still another aspect, a method of making a patterned surface structure on a resin is described. The method comprising contacting the methacrylate copolymer as described above with a patterned template, wherein the patterned template comprises a relief structure. In one embodiment, the methacrylate copolymer is part of a liquid composition which is coated onto the relief structure and subsequently dried. In another embodiment, the methacrylate copolymer is part of a dried layer and the relief structure is thermally embossed or thermally imprinted into the methacrylate copolymer.

The above summary is not intended to describe each embodiment. The details of one or more embodiments of the invention are also set forth in the description below. Other features, objects, and advantages will be apparent from the description and from the claims.

### BREIF DESCRIPTION OF THE DRAWINGS

The disclosure may be more completely understood in consideration of the following detailed description of various embodiments of the disclosure in connection with the accompanying figures, in which:
FIG. 1 is a process for forming a patterned resin from a patterned template shown by cross-sectional views of the construction, according to one embodiment.
FIG. 2 is a top view drawing of a tooling substrate comprising a plurality of nano-featured tiles, according to one embodiment.
FIG. 3 is a cross-sectional image of Example 4 taken by scanning electron microscopy (SEM).
FIG. 4 is a cross-sectional image of Example 6 taken by SEM.
FIG. 5A is a top view and Fig. 5B is a side view taken by SEM of the patterned template used in Example 7 and Fig. 6A is a top view and Fig. 6B is a side view taken by SEM of the patterned resin of Example 7.
FIG. 7 is a photograph of four tiles of a patterned resin described in Example 9.

While the above-identified drawings, some of which are not drawn to scale, set forth various embodiments of the present disclosure, other embodiments are also contemplated, as noted in the Detailed Description.

### DETAILED DESCRIPTION

Certain terms are used throughout the description and the claims that, while for the most part are well known, may require some explanation. As used herein, the term:
"a", "an", and "the" are used interchangeably and mean one or more;
"and/or" is used to indicate one or both stated cases may occur, for example A and/or B includes, (A and B) and (A or B);
"crosslinking" refers to connecting two polymer chains using chemical bonds or chemical groups;
"monomer" is a molecule which can undergo polymerization which then forms part of the essential structure of a polymer; and
"perfluorinated" means a group or a compound derived from a hydrocarbon wherein all hydrogen atoms have been replaced by fluorine atoms. A perfluorinated compound may however still contain other atoms than fluorine and carbon atoms, like oxygen atoms, chlorine atoms, bromine atoms, and iodine atoms.

Also herein, recitation of ranges by endpoints includes all numbers subsumed within that range (e.g., 1 to 10 includes 1.4, 1.9, 2.33, 5.75, 9.98, etc.).

Also herein, recitation of "at least one" includes all numbers of one and greater (e.g., at least 2, at least 4, at least 6, at least 8, at least 10, at least 25, at least 50, at least 100, etc.).

As used herein, "comprises at least one of" A, B, and C refers to element A by itself, element B by itself, element C by itself, A and B, A and C, B and C, and a combination of all three.

In the present disclosure, it has been found that the polymers disclosed herein (i.e., methacrylate copolymers) can be advantageously used to enable patterning of nanostructures.

### Polymer

The polymer of the present disclosure is a methacrylate copolymer derived from the copolymerization of at least 3 different (meth)acrylate monomers; (a) a (meth)acrylate monomer comprising a second terminal olefin group, (b) an alkyl methacrylate monomer, and (c) a mono(meth)acrylate monomer comprising a low-surface-energy group.

The (meth)acrylate monomer (a) comprises an acrylate (CH₂=CHC(O)O-) or methacrylate (CH₂=C(CH₃)C(O)O-) group as well as an additional (or second) terminal olefin group. In one embodiment, such monomers are of the formula CH₂=CQC(=O)L¹CH=CH₂, wherein Q is H or CH₃ and L¹ is a linking group comprising 1, 2, 3, 4, 5, 6, 7, 8, or 9 carbon atoms. In one embodiment, L¹ is -CH₂-, -CH₂CH₂-, -C(CH₃)HCH₂-, or -CH₂-. Exemplary a (meth)acrylate monomer comprising a second terminal olefin group include: CH₂=CCH₃C(=O)OCH₂CH=CH₂, CH₂=CCH₃C(=O)OCH=CH2, and CH₂=CHC(=O)OCH=CH₂.

The alkyl methacrylate monomer (b) comprises an alkyl group comprising 1 to 4 carbon atoms. In one embodiment, such monomers are of the formula CH₂=C(CH₃)C(=O)OR¹, wherein R¹ is the alkyl group. The R¹ alkyl group may be linear or branched in nature. In one embodiment, the alkyl group is -CH₃, -CH₂CH₃, -CH(CH₃)CH₃, -CH₂CH₂CH₃; -CH(CH₃)CH₂CH₃, - CH₂CH(CH₃)CH₃, -CH₂CH(CH₃)₂, -C(CH₃)₃, and -CH₂CH₂CH₂CH₃. Typically, the alkyl methacrylate monomer (b) should be one wherein the homopolymer of the alkyl methacrylate monomer has a glass transition temperature near or greater than room temperature (e.g., greater than 23, 25, 28, 30, or even 35°C).

The mono(meth)acrylate monomer (c) comprises a low-surface-energy group. Such low-surface-energy groups include a perfluorinated alkyl group, a perfluorinated polyether group, and/or a silicone group.

In one embodiment, the mono(meth)acrylate monomer (c) is of the formula CH₂=CQC(=O)OL²R² wherein Q is H or CH₃ and L² is a linking group comprising 1-9 carbon atoms and optionally at least one catenated ether group and R² comprises the silicone group. In one embodiment, the silicone group is -[Si (CH₃)₂-O]ᵣ-Si(CH₃)₂R⁴ wherein r is an integer from 1-200 and R⁴ is an alkyl group comprising 1-8 carbon atoms. The alkyl group of R⁴ may be linear, branched, or cyclic in nature. In one embodiment, the alkyl group of R⁴ is -CH₃, -CH₂CH₃, - CH(CH₃)CH₃, -CH₂CH₂CH₃; -CH(CH₃)CH₂CH₃, - CH₂CH(CH₃)CH₃, -CH₂CH(CH₃)₂, -C(CH₃)₃, - CH₂CH₂CH₂CH₃, and -(CH₂)₇CH₃. Such mono(meth)acrylate monomers include: CH₂=CHC(=O)O(CH₂)₃Si (CH₃)₂-[O-Si(CH₃)₂]ₙCH₂CH₂CH₂CH₃ where n is 1, 2, 3, 4, 5, 6, 7, 8, 9, 10, or 12.

In another embodiment, the mono(meth)acrylate monomer (c) is of the formula CH₂=CQC(=O)OL³R³ wherein Q is H or CH₃ and L³ is a linking group comprising at least one of an ether, ester, amide, or sulfonamide and R³ comprises the perfluorinated alkyl group, or the perfluorinated polyether group. Exemplary linking groups include -(CH₂)ᵣNHC(=O)- wherein r is an integer from 1 to 4. The perfluorinated alkyl group or perfluorinated polyether group of R³ can comprise 1 to 20 carbon atoms. Exemplary perfluorinated alkyl groups or perfluorinated polyether groups of R³ include: -(CₚF₂ₚ)-, -(CₚF₂ₚO)-, -(CF(Q¹))-, -(CF(Q¹)O)-, -(CF(Q¹)CₚF₂ₚO)-, - (CₚF₂ₚCF(Q¹)O)-, -(CF₂CF(Q¹)O)-, or combinations thereof. In these repeating units, p is typically an integer of 1 to 10. In some embodiments, p is an integer of 1 to 8, 1 to 6, 1 to 4, 1 to 3, or 1 to 2. The group Q¹ is a fluorine atom, perfluoroalkyl group, perfluoroether group, nitrogen-containing perfluoroalkyl group, perfluoropolyether, or a perfluoroalkoxy group, all of which can be linear, branched, or cyclic. The Q¹ group typically has no more than 12, 10, 9, 4, 3, 2, or even 1 carbon atom(s). In some embodiments, the Q¹ group can have no more than 4, 3, 2, or even 1 oxygen atoms, or even no oxygen atoms. In these perfluoropolyether structures, the different repeat units can be distributed randomly along the chain. Such mono(meth)acrylate monomers include: CH₂=CHC(=O) O(CH₂)₂NHC(=O)CF(CF₃)(OCF₂CFCF₃)ₙOC₃F₇.

The methacrylate copolymers of the present disclosure are made using a reversible addition-fragmentation chain-transfer (or RAFT) process. Such polymerization techniques are known in the art and the polymerization is mediated by a RAFT agent. In one embodiment, the RAFT agent is of the formula ZC(=S)SR, wherein R comprises at least one of a nitrile or ester functional group, and Z is -C₆H₅, N-(4-pyridinyl)-N-methylamine, or -SR⁵ where R⁵ is an alkyl group comprising 1-12 carbon atoms. Exemplary RAFT agents include: H₅C₆-C(=S)S-C(CH₃)₂C≡N, H₅C₆-C(=S)S-C(CH₃)(C≡N)CH₂CH₂C(=O)OH, H₂₅C₁₂-S-C(=S)S-C(CH₃)₂(C≡N), H₂₅C₁₂-S-C(=S)S-C(CH₃)(C≡N)CH₂CH₂C(=O)OH, and H₂₅C₁₂-S-C(=S)S-C(CH₃)₂C(=O)OH.

In one embodiment, the methacrylate copolymer comprising the RAFT polymerization of monomers (a), (b), and (c) results in a random polymer.

In one embodiment, the methacrylate copolymer is of the formula: 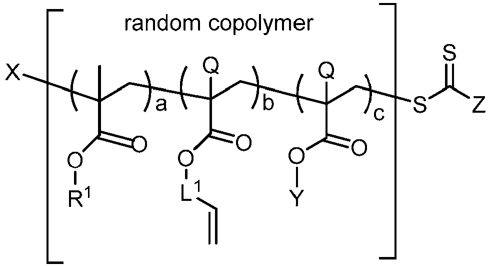 wherein:
R¹ is C1-C4 alkyl group;
L¹ is a linking group comprising 1-9 carbon atoms;
Y comprises a low-surface-energy group selected from -L²-R² or -L³-R³ wherein L² is a linking group comprising 1, 2, 3, 4, 5, 6, 7, 8, or 9 carbon atoms and optionally at least one catenated ether, R² comprises a silicone group, L³ is a linking group comprising at least one of an ether, ester, amide, or sulfonamide and R³ comprises a perfluorinated alkyl group or a perfluorinated polyether group;
each Q is independently selected from H or CH₃;
X comprises -C(CH₃)₂CN, -C(CH₃)₂C₆H₅, -CH(CN)C₆H₅, or -C(CH₃)₂C(=O)OC₂H₅;
Z is -C₆H₅, -SR⁵ where R⁵ is an alkyl group comprising 1-12 carbon atoms, or a monovalent pyrrole;
a is integer from 50 to 1000;
b is integer from 5 to 200; and
c is integer from 1 to 50.

In one embodiment, a is at least 50, 75, 100, 150, or even 200; and at most 1000, 900, 800, 700, 600, 500, 400, 300, or even 250. In one embodiment, b is at least 5, 8, 10, 20, 25, or even 40; and at most 200, 150, 100, 90, 80, 70, 60, 50 or even 45. In one embodiment, c is at least 1, 2, 3, 5, 8, 10, 15, or even 20; and at most 50, 40, 30, 25, or even 20.

In one embodiment, the methacrylate copolymer of the present disclosure has a number average molecular weight of at least 10,000; 20,000; 30,000; or even 40,000 Daltons; and at most 100,000; 90,000; 80,000; 70,000; or even 60,000 Daltons. The molecular weight of the polymer may be determined using techniques known in the art such as gel permeation chromatography.

In one embodiment, the methacrylate copolymer is derived from 0.5 to 30 % by mass, 5 to 20 % by mass, or even 8 to 15 % by mass of the (meth)acrylate monomer comprising a second terminal olefin group.

In one embodiment, the methacrylate copolymer is derived from 50 to 90 % by mass or even 70 to 80 % by mass of the alkyl methacrylate monomer.

In one embodiment, the methacrylate copolymer is derived from 0.5 to 30 % by mass, 5 to 20 % by mass, or even 8 to 15 % by mass of the (meth)acrylate monomer comprising a low-surface-energy group.

In some embodiments, the methacrylate copolymer is derived from a monomer other than monomers (a), (b) and (c).

In one embodiment, the methacrylate copolymer of the present disclosure has a glass transition temperature of at least 30, 40, 50, 60, 70, 80 or even 90 °C and at most 150, 140, 130, 120, 110, or even 100 °C. The glass transition temperature may be determined using differential scanning calorimetry as is known in the art.

### Liquid composition

The methacrylate copolymer of the present disclosure may be mixed with a solvent and crosslinking agent to form a liquid composition. In some embodiments, such liquid compositions can be used as a replication medium, which will be described hereafter.

The methacrylate copolymer disclosed herein can be crosslinked through the pendent terminal olefin with a suitable crosslinking agent. The crosslinking agent serves to control the glass transition temperature to allow for low temperature lamination. The crosslinking agent also reacts to further harden the resin creating a more durable patterned surface. In one embodiment, the crosslinking agent comprises a mono-functional or multi-functional (meth)acrylate, a multi-functional thiol, or a (meth)acrylamide. Such crosslinking agents are known in the art. For example, monofunctional acrylates include 2-phenoxyethyl acrylate or tetrahydrofurfuryl acrylate and difunctional acrylates include 1,6-hexanediol diacrylate, tripropylene glycol diacrylate, or tricyclodecane dimethanol diacrylate, butanoic acid, 4-oxo-4-[[3-oxo-3-[(1-oxo-2-propen-1-yl)oxy]ethoxy]propyl]thio]-, 2-[(1-oxo-2-propen-1-yl)oxy]ethyl ester (or TEDA), triacrylates such as trimethylolpropane triacrylate or ethoxylated trimethylolpropane triacrylate, tetraacrylates such as ethoxylated pentaerythritol tetraacrylate, or higher functional acrylates such as dipentaerythritol pentaacrylate. Multi-functional thiols including: glycol di(3-mercaptopropionate), tris[2-(3-mercaptopropionyloxy)ethyl]isocyanurate, trimethylolpropane tri(3-mercaptopropionate), pentaerythritol tetra(3-mercaptopropionate), and di-pentaerythritol hexa(3-mercaptopropionate).

The crosslinking agent may be added at an amount of at least 5, 8, or even 10 %; and at most 20, 18, 15, or even 12 % based on weight to the liquid composition excluding solvent (for example, the methacrylate copolymer, the crosslinking agent, and optionally added photoinitiator, stabilizer, and fillers, if used).

Generally, the solvent is selected such that the methacrylate copolymer is soluble in the solvent. Exemplary solvents include: propylene glycol methyl ether, propylene glycol n-propyl ether, propylene glycol methyl ether acetate, ethylene glycol propyl ether, and ethylene glycol butyl ether.

Other additives can be included in the liquid composition to assist with processing of the liquid composition and/or change its properties, such as photoinitiators, stabilizers, surfactants, plasticizers, etc. The additives are added in amounts sufficient to obtain the desired end properties.

In some embodiments, a photoinitiator is added to the liquid composition. Exemplary photoinitiators include diphenyl(2,4,6-trimethylbenzoyl)phosphine oxide (available under the trade designation OMNIRAD TPO from IGM Resins USA Inc., St. Charles, IL); diphenyl(2,4,6-trimethylbenzoyl)phosphine oxide (available under the trade designation OMNIRAD 819 from IGM Resins USA Inc., St. Charles, IL); bis(2,6-dimethoxybenzoyl)-(2,4,4-trimethylpentyl) phosphine oxide (available under the trade designation OMNIRAD 403 from IGM Resins USA Inc., St. Charles, IL); a 25:75 mixture, by weight, of bis(2,6-dimethoxybenzoyl)-2,4,4-trimethylpentyl phosphine oxide and 2-hydroxy-2-methyl-1-phenylpropan-1-one (available under the trade designation OMNIRAD 1700 from IGM Resins USA Inc., St. Charles, IL); a 1:1 mixture, by weight, of bis(2,4,6-trimethylbenzoyl)phenyl phosphine oxide and 2-hydroxy-2-methyl-1-phenylpropane-1-one (available under the trade designation OMNIRAD 4265 from IGM Resins USA Inc., St. Charles, IL); and ethyl(2,4,6-trimethylbenzoyl)phenyl phosphinate (available under the trade designation OMNIRAD TPO-L from IGM Resins USA Inc., St. Charles, IL), and combinations thereof.

In some embodiments, a stabilizer is added to prevent premature curing of the composition and/or inhibit free radical formation. Such stabilizers include antioxidants such as those known in the art (e.g., hindered phenols, phosphites, thioesters, and amines) and cure inhibitors or retardants such as butylated hydroxytoluene, quinones (e.g., hydroquinone, benzoquinone, etc.), nitrobenzene, 1,3,5-trinitrobenzene, sulfur, aniline, phenol, chloroanil, and the like. Exemplary stabilizers include 2,6-di-tert-butyl-4-methylphenol (BHT), 4-methoxyphenol, hydroquinone, 4-hydroxy-2,2,6,6-Tetramethylpiperidin-1-oxyl (4-hydroxy-TEMPO), and phenothiazene.

The liquid composition can be prepared by mixing desired amounts of the methacrylate copolymer, the crosslinking agent, solvent, and optionally additional additives in conventional processing equipment. During mixing, it generally is desirable to distribute the solid components uniformly. The mixing of the liquid composition typically occurs at ambient conditions.

The amount of solvent in the liquid composition may be adjusted, depending on the application so as to obtain a desired viscosity of the liquid composition. In one embodiment, the liquid composition comprises at least 70, 75, 80, or even 85 % by weight solvent. In one embodiment, the liquid composition comprises at most 95, 90, or even 85 % by weight solvent.

### Use

In one embodiment, the methacrylate copolymer disclosed herein can be used in replicating the surface relief of a patterned template. Discussed below are two different ways to pattern the methacrylate copolymer, imprint lithography and transfer lithography.

Transfer lithography, as used herein, refers to a method wherein a patterned template having a pre-defined relief structure is coated with a solution, which fills in the surface relief and then solidifies. Imprint lithography refers to a method wherein a solid layer comprising the methacrylate copolymer is thermo-mechanically deformed by the patterned template to replicate the relief structure into the solid layer comprising the methacrylate copolymer.

These techniques, imprint lithography and transfer lithography, allow for the duplication of nanostructures with high throughput. Generally, high resolution master molds are used as the initial patterned template. These high-resolution master molds are typically made using lithographic techniques on silicon wafers. These master molds tend to be expensive, fragile, have a small patterned area limited by the equipment size, and have limited pattern generation throughput to make them. Therefore, a high-resolution master mold may be used as the original template and then other, cheaper and/or more durable materials, are used to generate large area patterned tiled replicas, which can be subsequently used to create tooling.

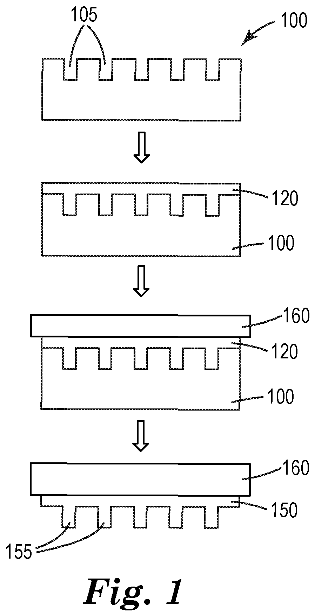

Shown in Fig. 1 is an exemplary process using the methacrylate copolymer of the present disclosure in a transfer process to make a finished nano-structured product from a patterned template. Fig. 1 depicts a cross-sectional view of the construction during processing and is not drawn to scale. Patterned template 100 comprises nano-sized features, in this case voids 105 which will be reproduced as pillars 155 on patterned resin 150. Patterned resin 150 is a negative image of patterned template 100. Patterned template 100 could be a high-resolution master mold, or an interim template. Because the process generates a negative of the patterned template, intermediate templates may be used to achieve the correct pattern of the final product as is routine in the art.

In Fig. 1, the liquid composition of the present disclosure is coated onto the surface of patterned template 100, filling voids 105. The coating is then solidified (for example, a solvent drying process, a reactive partial-curing process, etc.) to form replication medium 120. The solidification process results in a polymeric resin that is substantially solid (for example, having a glass transition temperature of at least 0, 5, 10, or even 20°C) at room temperature. The solid layer of replication medium substantially conforms to the structured surface of patterned template 100.

The liquid composition is disposed onto patterned template 100 and solidified thereon to form replication medium 120, which is a negative image of the template. The replication medium along its first side conforms to the patterned surface and forms a planar surface on a second side opposite the first side.

The second side of replication medium 120 may be disposed onto receiving substrate 160 as shown in Fig. 1. Receiving substrate 160 can aid handling of a thin replication medium. Receiving substrate 160 may include flexible polymeric substrates (such as polyethylene terephthalate, polycarbonate, cyclic olefin copolymer, etc.), glass, quartz, silicon wafers, polished metal, rigid polymer substrates, etc. In one embodiment, an adhesive may be used to adhere replication medium 120 to receiving substrate 160.

Typically, the replication medium, still in contact with the patterned template, is disposed onto a receiving substrate along its planar surface. This construction is then treated to crosslink (or further crosslink) the replication medium. The treatment to crosslink the replication medium will be dictated by its composition. For example, actinic radiation would be used along with a photoinitiator. Crosslinking of the replication medium forms patterned resin 150. The crosslinking of the methacrylate copolymer-containing replication medium enhances its mechanical properties, enabling separation/peeling of patterned resin 150 from patterned template 100 and retaining the relief structure, especially for nanostructures with high aspect ratio. The patterned template is removed resulting in patterned resin 150 comprising a relief surface, which is a negative of the template, disposed on receiving substrate 160.

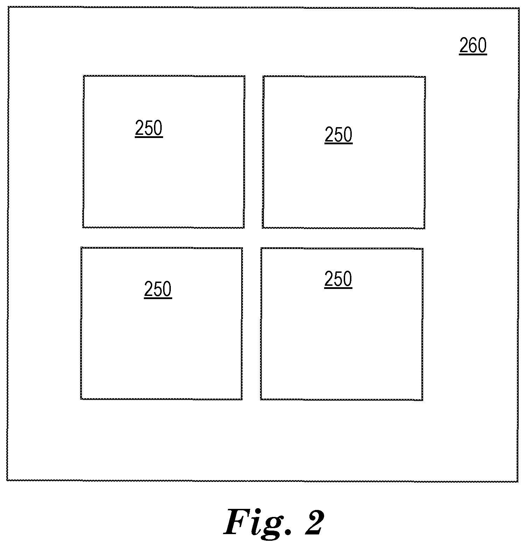

In one embodiment, the multilayered construction comprising the patterned template 100 and replication medium 120 are cut to a desired size and the planar surface of replication medium 120 is disposed onto a large receiving substrate. The construction is at least partially crosslinked and then patterned template 100 is removed leaving a tile of patterned resin on the receiving substrate. This process can be repeated resulting in many patterned resins on a receiving substrate. Shown in Fig. 2 is a top view depicting receiving substrate 260, with four tiles of patterned resin 250 thereon.

Fig. 1 is a simplified process, showing just one transfer process of a resin comprising the methacrylate copolymer presently disclosed. Those skilled in the art will recognize that other molding techniques can be used such that the correct molding form is achieved. Other techniques, such as coating with a release agent to facilitate separation of the patterned template from the patterned resin and/or coating with metal may be used. Such techniques are exemplified in the Example Section.

In an imprint method, the liquid composition as described above can be coated onto a substrate and allowed to solidify, for example by removing the volatile solvent to form a replication medium. Methods of solvent removal from the liquid composition can include at least partial evaporation at ambient conditions, or application of heat, reduced pressure, etc. to increase the rate of solvent evaporation. The patterned template would then be contacted with the replication medium and thermally embossed or thermally imprinted against each other, such that the negative image from the patterned template is transferred to the surface of the replication medium. Such methods of imprinting are known in the art. The replication medium can then be disposed onto a receiving substrate and crosslinked as described above, in the transfer process. The patterned template would then be removed, leaving a patterned resin disposed on a receiving substrate, similar to that described for the transfer method above.

The patterned template has a structured surface including an arrangement of pattern elements extending away from a base surface with voids formed between the pattern elements. The pattern elements or voids therebetween contain microscale and/or nanoscale feature(s) in a regular or random arrangement. In one embodiment, the patterned template comprises a structured surface including an arrangement of pattern elements extending away from a base surface thereof. In one embodiment, the pattern elements may have an average lateral dimension of at least 1, 5, 10, 20, 25, or even 50 nm. In one embodiment, the pattern elements may have an average lateral dimension of at most 1000, 500, 250, 200, 100, 50, or even 30 micrometers. In one embodiment, the pattern elements may have an aspect ratio of height to the lateral dimension of greater than 0, 0.5, 1, 1.5, or even 2; and at most 20, 10, 5. The patterned template can contain microscale and/or nanoscale feature(s) in a regular or random arrangement. The patterned template can be a precisely made structure, such as a silicon wafer master mold made using lithographic techniques or can be a replica made from a master mold referred to herein as an interim mold. Often these interim molds used a replication medium that comprised a curable polymeric resin, such as a reactive thermoplastic polymer, plasticized with a reactive crosslinker. Exemplary UV-curable resins include at least one of (meth)acrylate monomers, (meth)acrylate oligomers, epoxies, silicone, or silicone acrylate. Thus, the methacrylate copolymer disclosed herein may be used to generate a replica from a mold master such as a silicon master, or as exemplified in the examples below, from an interim mold.

In some embodiments, an adhesion promoter may be included as an additive in the replication medium or may be provided on the planar surface of the replication medium (120) prior to contacting to the receiving substrate (160) or an adhesion promoter may be provided on receiving substrate (160) prior to contact with the replication medium. Exemplary adhesion promoters include silane coupling agents such as 3-(trimethoxysilyl)propyl methacrylate or (3-trimethoxysilylpropylcarbamoyloxy)ethyl prop-2-enoate, described in Example 7 of U.S. Patent No 9,790,396.

The liquid composition of the present disclosure comprising the methacrylic copolymer is an especially useful precursor for replication medium (120). Because of the methacrylate copolymer's glass transition temperature, the liquid composition comprising the methacrylate copolymer of the present disclosure can be at least partially solidified, then the replication medium comprising the methacrylate copolymer can be crosslinked to increase its durability and enable the removal of the resulting patterned resin from the patterned template without damaging the pattern. For example, in one embodiment, the liquid composition of the present disclosure is first dried to remove solvent forming a methacrylate copolymer solid, which can be subsequently crosslinked by actinic radiation. Before applying the actinic radiation, the replication medium comprising the methacrylate copolymer has a lower glass transition temperature, which enables lamination of the solidified methacrylate copolymer composition onto a receiving substrate at low temperature. In one embodiment, the planar side of the solidified replication medium comprising the methacrylate copolymer of the present disclosure can be laminated to receiving substrate at a temperature of no more than 80, 70, 60, 50, or even 40 °C. The lamination of the replication medium comprising the methacrylate copolymer and the receiving substrate may be achieved by roller lamination, by manual lamination, by substrate-wide precision roll lamination, by deformable (membrane or compliant) lamination device, etc.

In one embodiment, the thickness of the patterned resin 150 has a residual thickness T, excluding the height of the pattern elements of the patterned resin 150. The residual thickness T may be on the order of the nano-structured depth or height, in a range, for example, from 10 nm to 1000 micrometers, or even greater than 1000 micrometers.

To use patterned resin 150 as described above to make large quantities of copies, in one embodiment, patterned resin 150 is cut into a "tile". A plurality of nano-featured tiles is disposed onto a receiving support to form a tooling which can be used to generate large area coverage nano- structured tools for pattern replication. Such a construction is shown in Fig. 2, which is a top view, depicting receiving substrate 260, with four nano-structured tiles 250 thereon. Although Fig. 2 shows a 2 tile by 2 tile array, any reasonable number of tiles can be used. Typically, each tile has an average area of, for example, 1 mm² to 2000000 mm². Often, there is a gap between the adjacent tiles in a range, for example, from about 0 mm to 100 mm. In the depicted embodiment, each tile of the array of patterns has a square shape, however, any shape can be envisioned (for example, rectangular, circular, etc.).

The patterned resin can be secured to the receiving substrate via various mechanisms including, for example, thermal exposure, thermal lamination, UV exposure or curing. In one embodiment, an additional adhesive layer (optical clear adhesive or OCA, etc.), coupling agents, surface treatments, degrading agents, etc. are used to assist securing the patterned resin to the receiving substrate.

In one embodiment, the liquid composition comprising the methacrylate copolymer as disclosed herein can be hardened through curing. One or more energy sources can be positioned such that emitted energy can cure the methacrylate copolymer. The energy source may be capable of emitting energy, e.g., actinic radiation, e-beam radiation, or heat. When the energy source emits radiation, the liquid composition and/or the patterned template can be substantially transparent to the radiation to allow curing of the replication medium. The term "substantially" with reference to a property or characteristic means that the property or characteristic is exhibited to a greater extent than the opposite of that property or characteristic is exhibited. For example, a substrate that is "substantially" transparent refers to a substrate that transmits more radiation (e.g., visible light) than it fails to transmit (e.g., absorbs and reflects). Thus, a substrate that transmits more than 50 % of the visible light incident upon its surface is substantially transparent, but a substrate that transmits 50 % or less of the visible light incident upon its surface is not substantially transparent.

The source(s) of actinic radiation is/are selected such that the actinic radiation is of an appropriate wavelength to be absorbed by the photoinitiator and organic photoactivatable reducing agent precursor. Exemplary sources of actinic radiation may include lasers (ultraviolet or visible), broad spectrum flashlamps (e.g., xenon flashlamps), and low-, medium-, and high-pressure mercury arc lamp mercury arc lamps, microwave-driven mercury lamps (e.g., using H-type, V-type, or D-type bulbs), and light emitting diode (LEDs). Further details associated with radiation curing are with the capabilities of those skilled in the art.

Advantageously, the methacrylate copolymer disclosed herein has a glass transition temperature greater than 0, 5, 10, 15 or even 20 °C, enabling the replication resin to be solid at room temperature, while also allowing low temperature lamination (e.g., less than 70 °C) of the solidified replication medium to be laminated onto a solid support. In one embodiment, the glass transition temperature of the replication medium (i.e., the methacrylate copolymer and any additives) is at least 30, 35, 40, or even 45 °C and at most 70, 65, 60, 55, or even 50 °C. Exemplary embodiments of the present disclosure provide a substantially solid replication medium at room temperature which is formed on a patterned template. The processes described herein can ease handling and storage during intermediate processing steps such as, for example, while coating or transferring replication medium on other patterned templates for other subregions on the same substrate. Embodiments of the present disclosure further provide a curable polymer resin replication medium having its planar surface in contact to a sub-region of a substrate. The replication medium should have a reduced glass transition temperature to allow the material to become substantially flowable in order to intimately contact with the planar surface to the substate. Embodiments described herein are advantageous as they reduce the process temperature and therefore reduce the potential for distortion of the relief structures of patterned templates due to mismatch of the thermal expansion coefficients of the patterned templates, replication medium, and receiving substrate.

### EXAMPLES

Unless otherwise noted, all parts, percentages, ratios, etc. in the examples and the rest of the specification are by weight, and all reagents used in the examples were obtained from EMD Millipore (Burlington, MA) and were used as received, or are available, from general chemical suppliers such as, for example, VWR, Radnor, PA, or may be synthesized by conventional methods. Table 1 (below) lists materials used in the examples and their sources.

**TABLE 1. Materials List**

| DESIGNATION | DESCRIPTION | SOURCE |
|---|---|---|
| MMA | Methyl methacrylate | Alfa Aesar (Haverhill, MA) |
| AMA | Allyl methacrylate | TCI America (Portland, OR) |
| HEA | 2-hydroxyethyl acrylate | TCI America |
| AuPd | Gold-palladium alloy | Denton Vacuum (Moorestown, NJ) |
| MCR-M07 | Silicone methacrylate macromonomer available under the trade designation MCR-M07 | Gelest (Morrisville, PA) |
| RAFT agent | 2-(2-cyano-2-propyl)-S-dodecyltrithiocarbonate | Strem (Newburyport, MA) |
| VAZO-67 | 2,2'-Azobis(2-methylbutyronitrile) | Chemours (Wilmington, DE) |
| TPO | Diphenyl(2,4,6-trimethylbenzoyl)phosphine oxide a photo initiator obtained under the trade designation OMNIRAD TPO | IGM Resins (Charlotte, NC) |
| DOWANOL PM | 1-Methoxy-2-Propanol | Millipore Sigma (St. Louis, MO) |
| HMDSO | Hexamethyldisiloxane | Millipore Sigma |
| K90 | 2-(3-trimethoxysilylpropylcarbamoyloxy)ethyl prop-2-enoate | Prepared as described in Example 7 of U.S. Patent No. 9,790,396 (Klun et al.) |
| PHOTOMER 6210 | Urethane acrylate oligomer obtained under the trade designation PHOTOMER 6210 | IGM Resins (Charlotte, NC) |
| SR238 | 1,6-Hexandiol diacrylate obtained under the trade designation SR238 | Sartomer (Exton, PA) |
| SR351 | Trimethylolpropane triacrylate obtained under the trade designation SR351 | Sartomer |
| ST504 | Polyester film available under the trade designation MELENEX ST504 | Tekra, Inc. (New Berlin, WI) |
| TE1 | 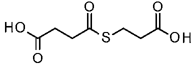 | Prepared as described in *Nat. Commun.* 2018, 9 (1) |
| TEDA | 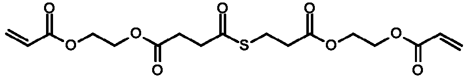 | Prepared as described in Preparative Example 3 |
| PETMP | Pentaerythritol tetrakis(3-mercaptopropionate) | Bruno Bock (Teaneck, NJ) |
| HFPO-MA | 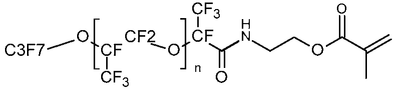 | Prepared as described in U.S. Patent Appl. Publ. No. 2004/0077775 A1 (Audenaert et. al.) |
| NOVEC 7100 | Methoxy-nonafluorobutane available under the trade designation 3M NOVEC 7100 ENGINEERED FLUID | 3M Company |
| BHT | 3,5-Di-*tert*-4-butylhydroxytoluene | Millipore Sigma |
| DIC | *N,N*'-Diisopropylcarbodiimide | Millipore Sigma |
| DPTS | 4-(dimethylamino)pyridinium 4-toluenesulfonate | Prepared as described in *Macromolecules* **1990,** 23, 70-77. |
| PET Film | a 75-micron thick biaxially-oriented polyethylene terephthalate (PET) film (prepared in-house) primed with an thermoset acrylic binder available under the trade designation RHOPLEX 3208 from Dow Chemical Co. Midland, MI | Made in-house |
| UVCur26SF | UV curable resist developed for inkjet dispensing obtained under the trade designation mr-UVCUR26SF | Micro resist technology GmbH, Berlin, Germany |

### TEST METHODS

### Method for Collecting Scanning Electron Microscopy (SEM) Images

Samples were mounted on aluminum examination stubs and coated with AuPd by sputtering to ensure conductivity. Sputtering was performed using a Desk V Sample Preparation System (Denton Vacuum) using direct current mode with a current of 20 milliamps for 30 seconds. Examinations were performed in a Hitachi S4700 Field Emission Scanning Electron Microscope (Hitachi, Tokyo, Japan).

### PREPARATIVE EXAMPLE 1

Resin A was prepared by combining PHOTOMER 6210, SR238, SR351 and TPO in weight ratios of 60/20/20/0.5. After all components were added, the resin mixture was blended by warming to approximately 50°C and mixing for 12 hours on a roller mixer. The mixture was blended until it appeared homogeneous.

### PREPARATIVE EXAMPLE 2

Glass was prepared by rinsing a 2 by 3 inch (5.1 cm (centimeter) by 7.6 cm) borosilicate microscope slide (Fisher Scientific, Hampton, NH) with acetone and isopropyl alcohol, wiping with a Vectra TX1010 clean room wipe (Texwipe, Kernersville, NC). The cleaned glass was dip coated in a solution containing 0.5 % by weight K90 in methyl ethyl ketone. The coated slide was baked at 140 °C for 15 minutes before cooling to room temperature.

### PREPARATIVE EXAMPLE 3

### Synthesis of TEDA

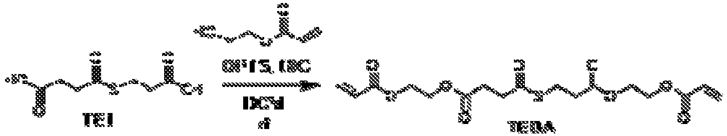

To a 500 mL (milliliters) round bottom flask equipped with a stir bar was added TE1 (20. g, 97 mmol, 1.0 equiv), BHT (2.14 g, 9.70 mmol, 0.100 equiv), and dichloromethane (DCM, 324 mL). To the heterogeneous mixture was added DPTS (1.43 g, 8.85 mmol, 0.05 equiv,) and 2-hydroxyethyl acrylate (20.05 mL, 174.6 mmol, 1.8 equiv). The mixture was stirred for 5 min at rt (room temperature) then DIC (33.04 mL, 213.4 mmol, 2.2 equiv) was added via a syringe. The reaction was stirred for 18 h at room temperature, after which the solids were filtered and washed with ethyl acetate (3 x 10 mL), the organic layer was collected and partially concentrated under reduced pressure. When approximately 1/3 of the liquid remained, the heterogeneous mixture (white solids in pale yellow viscous liquid) were filtered and washed with ethyl acetate (3 x 3 mL). This process was repeated once more then concentered in a fume hood over night by blowing house air over the liquid. When the resulting material was a viscous yellow oil, it was purified via automated column chromatography using a Biotage Isolara One (Biotage, Uppsala, Sweden) and the appropriate Biotage Sfär Flash purification column. The eluent was a hexane/ethyl acetate gradient from 80/20 to 20/80 volume/volume. The desired product was collected and concentrated by blowing house air overnight yielding a clear viscous oil (37.2 g, 95.3% yield).

### EXAMPLE 1: Preparation of a copolymer of MMA, AMA, and MCR-M07

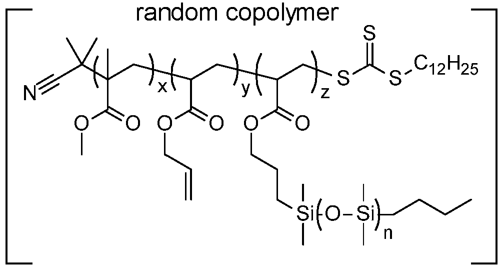

The reagents shown in Table 2 were added to a 1000 milliliter (mL), 3-necked round-bottom flask. A stir bar was added, and the flask was connected to a nitrogen manifold and equipped with a thermocouple, condenser, and rubber septum. The solution was deoxygenated by bubbling nitrogen gas for 10 minutes via a needle placed through the septum. The flask was immersed in an oil bath and heated while stirring to maintain a reaction temperature of 65-67 °C for 16 hours. During this time an increase in viscosity was observed. Analysis of an aliquot by ¹H NMR indicated a conversion of 59% of MMA monomer to polymer. The reaction was then cooled and exposed to air. The solution was diluted with acetonitrile (200 mL) and isopropanol (60 grams (g)), and the resulting solution was transferred to a separatory funnel. The polymer solution was washed twice with heptane (360 g). The solution was then transferred to a 2-liter (L) round-bottom flask and DOWANOL PM (260 g) was added. The solvent was distilled at reduced pressure using a rotary evaporator until the total solution mass equaled 300 g. A second portion of DOWANOL PM (260 g) was added, and the solvent was distilled at reduced pressure using a rotary evaporator until the total solution mass equaled 260.3 g. A small aliquot was evaporated to dryness (e.g., a small aliquot was heated at 150 °C for at least 1 hour) and the change in mass was used to determine a polymer concentration of 22.8%. This implies a yield of 59.4 g of polymer.

**TABLE 2. Reagents for the synthesis of the copolymer of Example 1**

| REAGENT | FORMULA WEIGHT, G/MOL | MILLI MOLES | MASS, G | CONCENTRATION | MOLAR EQUIVALENTS |
|---|---|---|---|---|---|
| MMA | 100.12 | 824 | 82.5 | | 670 |
| AMA | 126.15 | 87.2 | 11.0 | | 71 |
| MCR-M07 | 700 | 15.7 | 11.0 | | 13 |
| RAFT agent | 345.63 | 1.23 | 4.28 | 10% in acetonitrile | 1 |
| VAZO-67 | 192.26 | 0.25 | 4.76 | 1% in acetonitrile | 0.2 |
| Acetonitrile | | | 75.0 | | |

### EXAMPLE 2: Preparation of a copolymer of MMA, AMA, and HFPO-MA

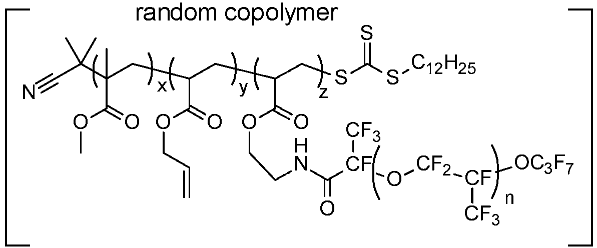

The reagents shown in Table 3 were added to a 1000 mL, 3-necked round-bottom flask. A stir bar was added to the solution, and the flask was connected to a nitrogen manifold and equipped with a thermocouple, condenser, and rubber septum. The solution was deoxygenated by bubbling nitrogen gas for 10 minutes via a needle placed through the septum. The solution was heated using a heating mantle while stirring to maintain a reaction temperature of 72 °C for 5 hours. During this time an increase in viscosity was observed. Analysis of an aliquot by ¹H NMR (nuclear magnetic resonance) indicated a conversion of 60% of MMA monomer to polymer. The solution was exposed to air, and then allowed to cool. The polymerization solution was then poured into a beaker containing NOVEC 7100 (750 g) while stirring, resulting in precipitation of the polymer. The polymer was isolated by filtration and washed with NOVEC 7100 (200 g). The solid polymer plus DOWANOL PM (400 g) was then transferred to a 1000 mL round-bottom flask. The polymer was dissolved by rotating the flask on a rotary evaporator. Solvent was then distilled using the rotary evaporator until the total solution mass was 250 g. A small aliquot was evaporated to dryness and the change in mass was used to determine a polymer concentration of 23.0%. This implies a yield of 57.5 g of polymer.

**TABLE 3: Reagents for the synthesis of the copolymer of Example 2**

| REAGENT | FORMULA WEIGHT, g/mol | MILLI MOLES | MASS, g | CONCENTRATIO N | MOLAR EQUIVALENTS |
|---|---|---|---|---|---|
| MMA | 100.12 | 824 | 82.5 | | 223 |
| AMA | 126.15 | 87.2 | 11.0 | | 24 |
| HFPO-MA | 1500 | 7.3 | 11.0 | | 2 |
| RAFT agent | 345.63 | 3.7 | 12.8 | 10% in ethyl acetate | 1 |
| VAZO-67 | 192.26 | 0.744 | 0.143 | | 0.2 |
| Ethyl acetate | | | 75.0 | | |

### EXAMPLE 3: Preparation of a Liquid Composition

A liquid composition was prepared by mixing the copolymer of Example 1 (10 g), TEDA (250 milligrams (mg)), TPO (253 mg of a 10% solution in DOWANOL PM), and DOWANOL PM (14.8 g).

### EXAMPLE 4: Preparation of a patterned resin comprising the copolymer of Example 1

### Resin A patterned template

A nano-featured template was prepared by die coating Resin A onto a Multilayer Film A. Multilayer Film A was prepared using the method described in PCT Publ. No. WO 2019/032635 A1 (Johnson, et al.). The resulting multilayer film had a 43-micron polyethylene terephthalate (PET) layer, a 6 to 7 micron linear B-E-S triblock copolymer layer ("KRATON G1645"), a 6 to 7-micron layer comprising a blend of 60 parts by weight polypropylene random copolymer ("PP9074MED") and 40 parts by weight B-E-S triblock copolymer ("KRATON G1645") and a 15 micron PETG copolyester layer ("EASTAR GN071"). The Resin A side of the coated film was pressed against a nanostructured nickel surface attached to a steel roller controlled at 60 °C using a rubber covered roller at a speed of 15.2 meters/minute. The nanostructured nickel tool consists of one 5 cm by 7.5 cm patterned area with hole features. The features were 450 nanometer (nm) tall cylinders with diameters of 150 nm in a random array with repeating unit squares of about 25 µm by 25 µm. The coating thickness of Resin A on the Multilayer Film A was sufficient to fully wet. The nickel surface and form a rolling bead of resin as the coated film was pressed against the nanostructured nickel surface. The Resin A coating was exposed to radiation from two Fusion UV lamp systems (obtained under the trade designation "F600" from Fusion UV Systems, Gaithersburg, MD) fitted with D bulbs both operating at 142 watt/centimeter (W/cm) while in contact with the nanostructured nickel surface. Peeling the coated film from the nanostructured nickel surface resulted in nanostructured features in Resin A. The nanostructured side of the coated film was exposed again to radiation from the Fusion UV lamp system to form a patterned template comprising Resin A with nanostructured features atop Multilayer Film A.

### Release-treating Resin A patterned template

A silicon-containing release film layer assembled according to methods described in U.S. Patent Nos. 6696157 (David et al.) and 8664323 (Iyer et al.) and U.S. Patent Publication No. 2013/0229378 (Iyer et al.) was applied to the Resin A patterned template from above in a parallel-plate capacitively coupled plasma reactor to form a silicon-containing release surface on top of the nanostructured Resin A. The chamber has a central cylindrical powered electrode with a surface area of 1.7 m² (18.3 ft²). After placing the Resin A patterned template on the powered electrode, the reactor chamber was pumped down to a base pressure of less than 1.3 Pascal (Pa) (2 millitorr (mTorr)). O₂ gas was flowed into the chamber at a rate of 1000 standard cubic centimeters per minute (SCCM). Treatment was carried out using a plasma-enhanced CVD method by coupling radio frequency (RF) power into the reactor at a frequency of 13.56 megahertz (MHz) and an applied power of 2000 watts (W). Treatment time was controlled by moving the polymeric nanostructured template through the reaction zone at rate of 9.1 meters/minute (30 feet/minute) resulting in an approximate exposure time of 10 seconds. After completing the deposition, RF (radio frequency) power was turned off and gases were evacuated from the reactor. Following the first treatment, a second plasma treatment was carried out in the same reactor without returning the chamber to atmospheric pressure. HMDSO gas was flowed into the chamber at approximately 1750 SCCM to achieve a pressure of 9 mTorr. 13.56 MHz RF power was subsequently coupled into the reactor with an applied power of 1000 W. The patterned template was then carried through the reaction zone at a rate of 9.1 meters/minute (30 feet/minute) resulting in an approximate exposure time of 10 seconds and a coating thickness of about 5 to 10 nm. At the end of this treatment time, the RF power and the gas supply were stopped, and the chamber was returned to atmospheric pressure. This resulted in a release-treated Resin A patterned template.

### Patterned resin comprising methacrylate copolymer

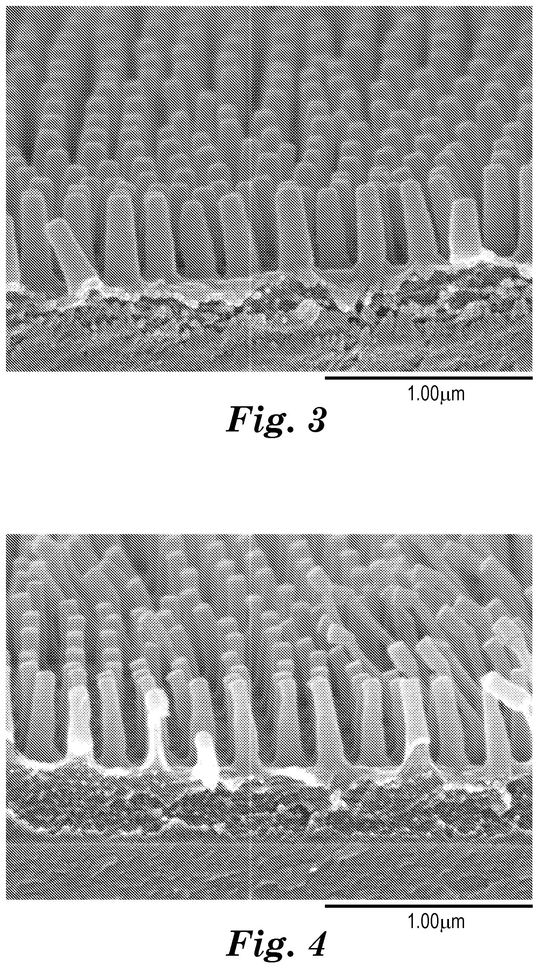

The liquid composition of Example 3 was used to spin coat a layer of liquid composition onto the release treated Resin A patterned template. The spin coating conditions were 500 revolutions per minute (rpm) for 5 seconds and 1000 rpm for 30 seconds after statically applying 1 mL of solution to cover the nano-featured region to coat the patterned template with the methacrylate copolymer resin. The planar surface of the replication medium was laminated to a treated glass with a hot roll laminator at the lowest speed setting at a temperature of 175 °F (79.4 °C). The nip was engaged with 60 pounds per square inch (psi) (0.41 megapascals (MPa)) to conform the replication medium to the treated glass. The resulting construction was crosslinked using a Fusion D-bulb (Fusion Light Hammer 10, Heraeus, Hanau, Germany) at 100% intensity and a belt speed of 50 feet/minute (fpm) (15.2 meters/minute). The construction was then peeled apart to separate the release-treated Resin A patterned template from the patterned resin made from the liquid composition of Example 3. Scanning electron microscopy (SEM) was used to obtain images of the resulting patterned resin according to the Test Method (see Fig. 3), which show good fidelity to the original nanostructured nickel tool.

### EXAMPLE 5: Preparation of a Liquid Composition

A liquid composition was prepared by mixing the polymer of Example 1 (100 g), PETMP (2.53 g), TPO (2.53 g of a 10% solution in DOWANOL PM), and DOWANOL PM (148 g).

### EXAMPLE 6: Preparation of a nano-featured patterned tooling comprising the liquid composition of Example 5

### Resin A patterned template

A nano-featured template was prepared as described in Example 4, except 3 mil thick (0.08 millimeters (mm)) by 12.0 inch-wide (30 cm) PET film was used, resulting in Resin A with nanostructured features atop the PET film.

### Release-treating Resin A patterned template

The Resin A patterned template was treated with silicon using the procedure as described in Example 4. SEM was used to obtain images of the release-treated Resin A patterned template according to the Test Method.

### Patterned resin comprising methacrylate copolymer

The liquid composition of Example 5 was die coated in a roll-to-roll process onto the release treated Resin A patterned template from above with a slot die at a rate of 10 feet/minute (0.051 meters/second (m/s)). The solution was coated 5.0 inches (13 cm) wide with a 3.0 mil (0.0076 cm) slot height and pumped with a PHD 2000 Syringe Infuse/Withdraw syringe pump (Harvard Apparatus, Holliston, MA) at a rate of 3.5 SCCM. The coating was dried at room temperature for 2 minutes to create replication medium on the patterned template. LD-K1010-75 (Showa Denko Materials Co. LTD, Tokyo, Japan) liner was temporarily laminated to the planar surface of the replication medium. Prior to attachment to the receiving substrate, the LD-K1010-75 was removed and the planar surface of the replication medium was transfer to treated glass and cured as described for Example 4, except the sample was cured with the JL3-Series LED (Clearstone Technologies, Hopkins, MN) with a wavelength of 455 nm at 100% intensity for 3 minutes. The light was controlled with a Clearstone Technologies CF 2000 standard bench-top UV LED power supply. The patterned template was removed from the patterned resin. SEM was used to obtain images of the patterned resin, according to the Test Method (see Fig. 4), which showed good fidelity to the original nanostructured nickel tool.

### EXAMPLE 7: Preparation of a patterned resin comprising the methacrylate copolymer of Example 1

### Resin A patterned template

A nanostructured template of Resin A was prepared as described in Example 4, except 5.0 mil-thick (0.13 mm) by 9.0 inch-wide (23 cm) polycarbonate film was used in place of Multilayer film A and a nickel tool consisting of one roughly 5 cm x 5 cm patch of regularly spaced 200 nm diameter holes was used, which was held at 66 °C.

### Release treating Resin A patterned template

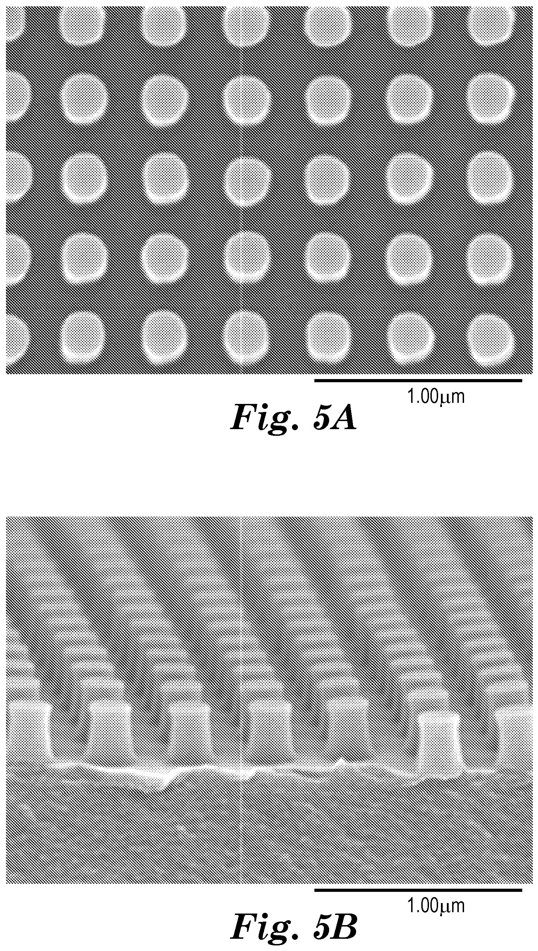

The Resin A patterned template was coated with silicon using the procedure as described in Example 4. SEM was used to obtain images of the release treated Resin A patterned template according to the Test Method. See Fig. 5 A and 5B.

### Patterned template comprising methacrylate copolymer

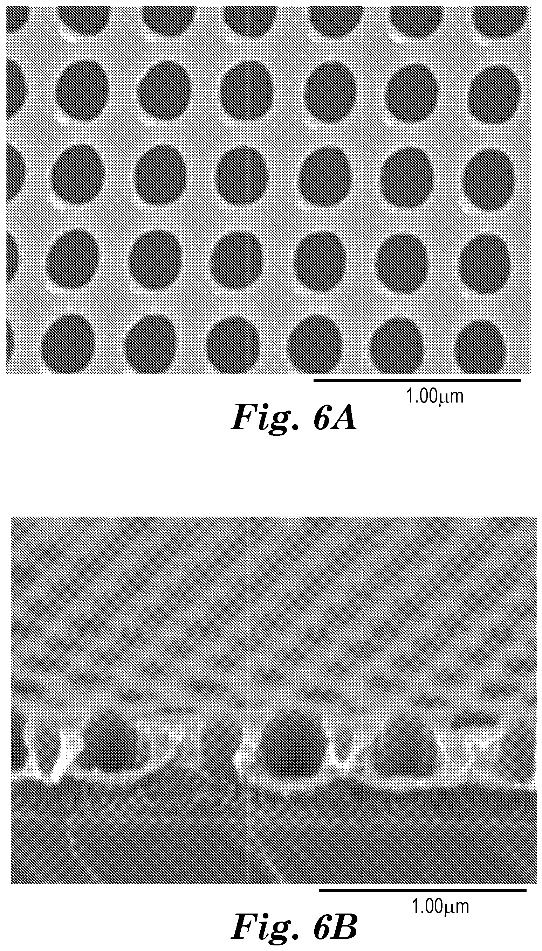

The liquid composition of Example 3 was used to spin coat a layer of liquid onto the Release-treated Resin A patterned template. The spin coating conditions were 500 revolutions per minute (rpm) for 5 seconds and 1000 rpm for 30 seconds after statically applying 1 mL of the liquid composition to cover the nano-featured region of the release treated Resin A patterned template. The replication medium was then transferred onto glass and cured as described in Example 4. SEM was used to obtain images of the resulting patterned resin made from Example 3 according to the Test Method. See Fig. 6A and 6B. Comparison of the Release treated Resin A patterned template shown in Figs. 5A (top-view) and 5B (side-view) and the resulting patterned resin comprising methacrylate copolymer shown in Figs. 6A (top-view) and 6B (side-view) show good fidelity.

### EXAMPLE 8: Preparation of a Liquid Composition

A liquid composition was prepared by mixing the polymer of Example 1 (10 g), TEDA (253 mg), TPO (253 mg of a 10% solution in DOWANOL PM), and DOWANOL PM (6.4 g).

### EXAMPLE 9: Preparation of a 2 x 2 tiled array

A polymeric patterned template was generated from a lithographically mastered 100 mm diameter silicon master containing a relief structure of a line gradings with a pitch of 400 nm, a depth of 200 nm, and a duty cycle of 50 percent as well as a 10 mm wide region without line gradings 30 mm from the edge of the silicon spanning the length of the template in the direction parallel to the line gradings. The silicon master was release treated prior to the polymeric template generation. The relief surface of the silicon master was treated with thin layer (e.g., monolayer) of a low-surface-energy fluorinated silane after O₂ plasma activation of the surface to aid release. O₂ plasma activation was carried out with RF power of 50 W for 5 minutes and at a steady state pressure of 1.0 Pa (Pascal, 75 mTorr).

The polymeric patterned template was generated by depositing 0.5 mL of MR-UVCur26SF onto the relief surface of the release-treated silicon master and a ST504 film was laminated with a rubber roller to spread the MR-UVCur26SF material over the entire relief structure. The MR-UVcur26SF was cured with the custom low power UV-LED unit with a wavelength of 385 nanometer (nm) at 40 volts (V), 8 ampere (A) for 2 minutes through the ST504 PET film. The ST504 PET film and MR-UVCur26SF materials were peeled from the silicon master to expose the inverse relief structure in the MR-UVCur26SF material. This was repeated four times using the same silicon master to generate each polymeric template.

The ST504 PET used to generate the polymeric patterned template was modified to improve adhesion by using plasma etching with a home-built parallel plate capacitively coupled plasma reactor as described in U.S. Patent Nos. 6,696,157 David, et. al). The chamber has a central cylindrical powered electrode with a surface area of 1.7 meter squared (m², 18.3 ft²). After placing the film on the powered electrode, the reactor chamber was pumped down to a base pressure of less than 1.3 Pa (2 mTorr). O₂, and HMDSO gasses were flowed into the chamber at a rate 20 SCCM, and 750 SCCM, respectively. Treatment was carried out using a reactive ion etching method by coupling RF power into the reactor at a frequency of 13.56 MHz and an applied power of 7500 watts. Treatment time was controlled by moving the film through the reaction zone at rate of 3 meters/minute (10 feet/minute), resulting in an approximate exposure time of 30 seconds. At the end of this treatment time, the RF power and the gas supply were stopped, and the chamber was returned to atmospheric pressure.

A silicon containing release layer assembled according to the "method for release treatment" described in WO2020/095258 (Van Lengerich et al.) was applied to the polymeric patterned template.

The liquid composition of Example 8 was spin coated onto the release treated patterned template. The spin coating conditions were 500 rpm for 5 seconds and 1000 rpm for 60 seconds after statically applying 6 mL of solution to cover the nano-featured region of the template. The coating was let dry for 60 seconds to form the replication medium before applying an oversized LD-K1010-75 liner to the planer surface. The liner, replication medium, and patterned template were cut down to an 85 mm diameter circle. This process was repeated to generate 4 circles (or tiles).

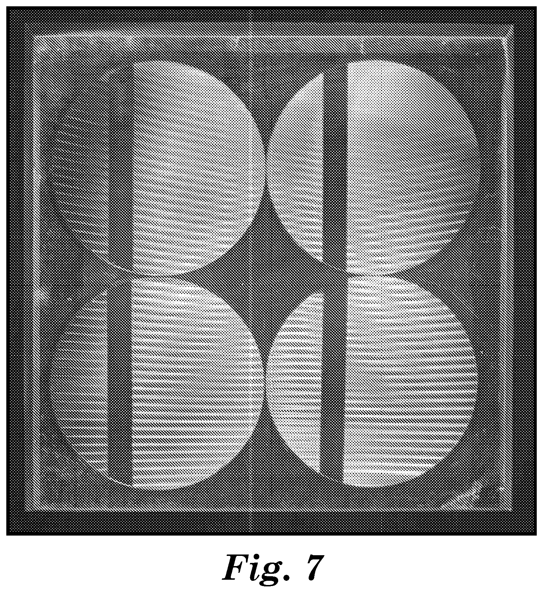

The circles were laid in a membrane laminating unit with the LD-K1010-75 surface of the circles in contact with the bottom of the unit. The membrane laminating unit contained an upper and lower compartment which were separated by a silicone membrane. Vacuum could be applied to each chamber separately and pressure could be applied to the top. Vacuum was pulled on both units at a rate to avoid touchdown of the membrane until 26.7 Pa (200 mtorr) was reached. The top was then vented to atmosphere followed by venting the bottom to atmosphere. The LD-K1010-75 was removed from the circles and a prepared glass was placed at the bottom of the unit. The glass was prepared as in Example 4, except Corning EAGLE XG 200.0 x 200.0 x 0.70 mm glass (Precision Glass & Optics, Santa Ana, CA) was used. A vacuum was pulled on the upper and lower chambers at a rate which avoided touchdown of the replication medium to the receiving substrate (or glass) until a vacuum was reached. Then the top chamber was then pressurized to 0.41 MPa (60 psi) enabling contact of the replication medium with the receiving substrate. The unit was heated on a hot plate until the internal temperature of the bottom platen reached 45 °C. The top chamber was vented to atmosphere. While still in the laminating unit and the bottom chamber under vacuum, a custom low power UV-LED unit with a wavelength of 385 nm at 40 volts (V), 8 ampere (A) was directed toward the patterned template and was applied for 5 minutes to cure the replication medium. Then, the bottom chamber was vented to atmosphere, and the glass/patterned resin/patterned template construction was removed. The patterned templates from each of the circles (or tiles) were removed to expose the patterned resin. Shown in Fig.7 are the 4 tiles of patterned resin made from the methacrylate copolymer resin according to the present disclosure.

## Claims

1. A polymer derived from:
(a) a (meth)acrylate monomer comprising a second terminal olefin group;
(b) an alkyl methacrylate monomer wherein the alkyl group comprises 1 to 4 carbon atoms;
(c) a mono(meth)acrylate monomer comprising a low-surface-energy group, wherein the low-surface-energy group comprises a perfluorinated alkyl group, a perfluorinated polyether group, or a silicone group;
(d) a reversible addition-fragmentation (RAFT) agent.

2. The polymer of claim 1, wherein the (meth)acrylate monomer comprising a second terminal olefin group is of the formula CH₂=CQC(=O)L¹CH=CH₂, wherein Q is H or CH₃ and L¹ is a linking group comprising 1 to 9 carbon atoms,
optionally wherein L¹ is CH₂.

3. The polymer of any one of the previous claims, wherein the alkyl methacrylate monomer is of the formula CH₂=C(CH₃)C(=O)OR¹, wherein R¹ is C1 to C4 alkyl group,
optionally wherein R¹ is -CH₃, -CH₂CH₃, -CH(CH₃)CH₃, -CH₂CH₂CH₃, ₋CH(CH₃)CH₂CH₃, -CH₂CH(CH₃)CH₃, or -C(CH₃₎₃.

4. The polymer of any one of the previous claims, wherein a homopolymer of the alkyl methacrylate monomer has a glass transition temperature greater than room temperature.

5. The polymer of any one of the previous claims, wherein the mono(meth)acrylate monomer is of at least one of the following formulas:
CH₂=CQC(=O)OL²R² wherein Q is H or CH₃ and L² is a linking group comprising 1 to 9 carbon atoms and optionally a catenated ether group and R² comprises the silicone group; or
CH₂=CQC(=O)OL³R³ wherein Q is H or CH₃ and L³ is a linking group comprising at least one of an ether, ester, amide or sulfonamide and R³ comprises the perfluorinated alkyl group, or the perfluorinated polyether group.

6. The polymer of any one of any one of claims 1-5, wherein the perfluorinated polyether group comprises repeating units selected from the group of -(CpF2p)-, - (CpF2pO)-, -(CF(Q¹))-, -(CF(Q¹)O)-, -(CF(Q¹)CpF2pO)-, -(CpF2pCF(Q¹)O)-, or - (CF2CF(Q¹)O)-, wherein
p is an integer from 1 to 10; and
Q¹ is a fluorine atom, perfluoroalkyl group, perfluoroether group, nitrogen-containing perfluoroalkyl group, perfluoropolyether, or a perfluoroalkoxy group.

7. The polymer of any one of any one of claims 1-5, wherein the silicone group is -[Si (CH₃)₂-O]ᵣ-Si(CH₃)₂R⁴ wherein r is an integer from 1 to 200 and R⁴ is an alkyl group comprising 1 to 8 carbon atoms.

8. The polymer of any one of the previous claims, wherein the RAFT agent is of the formula ZC(=S)SR, wherein R comprises at least one of a nitrile or ester functional group, and Z is -C₆H₅, N-(4-pyridinyl)-N-methylamine, or -SR⁵ where R⁵ is an alkyl group comprising 1-12 carbon atoms.

9. A polymer comprising: 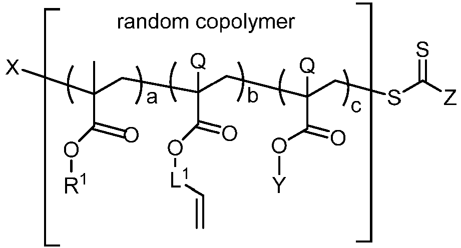 wherein:
R¹ is alkyl group comprising 1 to 4 carbon atoms;
L¹ is a linking group comprising 1 to 9 carbon atoms, optionally wherein L¹ is CH₂;
Y is a releasable group selected from -L²-R² or -L³-R³ wherein L² is a linking group comprising 1 to 9 carbon atoms and optionally at least one catenated ether, R² comprises a silicone group, L³ is a linking group comprising at least one of an ether, ester, amide or sulfonamide, and R³ comprises a perfluorinated alkyl group or a perfluorinated polyether group;
each Q is independently selected from H or CH₃;
X comprises -C(CH₃)₂CN, -C(CH₃)₂C₆H₅, -CH(CN)C₆H₅, or -C(CH₃)₂C(=O)OC₂H₅;
Z is -C₆H₅, -SR⁵ where R⁵ is an alkyl group comprising 1-12 carbon atoms, or a monovalent pyrrole;
a is an integer from 50 to 1000;
b is an integer from 5 to 200; and
c is an integer from 1 to 50.

10. The polymer of claim 9, wherein R¹ is -CH₃, -CH₂CH₃, -CH(CH₃)CH₃, -CH₂CH₂CH₃, CH(CH₃)CH₂CH₃, -CH₂CH(CH₃)CH₃, or -C(CH₃)₃.

11. The polymer of claim 9, wherein the perfluorinated alkyl group is a linear, branched, or cyclic alkyl group comprising 1 to 10 carbon atoms.

12. The polymer of claim 9, wherein the perfluorinated polyether group comprises repeating units selected from the group of -(CpF2p)-, -(CpF2pO)-, -(CF(Q¹))-, - (CF(Q¹)O)-, -(CF(Q¹)CpF2pO)-, -(CpF2pCF(Q¹)O)-, or -(CF2CF(Q¹)O)-,
wherein:
p is an integer from 1 to 10; and
Q¹ is a fluorine atom, perfluoroalkyl group, perfluoroether group, nitrogen-containing perfluoroalkyl group, perfluoropolyether, or a perfluoroalkoxy group.

13. The polymer of claim 9, wherein the silicone group is -[Si (CH₃)₂-O]ᵣ -Si(CH₃)₂R⁴ wherein r is an integer from 1 to 200 and R⁴ is an alkyl group comprising 1 to 8 carbon atoms.

14. A liquid composition comprising:
(a) a polymer according to any one of the previous claims;
(b) a crosslinking agent, optionally wherein the crosslinking agent comprises a (meth)acrylate, a multi-functional thiol, a (meth)acrylamide, or combinations thereof;
(c) solvent; and
(d) optionally, a photoinitiator; and
(e) optionally, a stabilizer, optionally wherein the stabilizer comprises at least one of 2,6,di-tert-butyl-4-methylphenol (BHT), 4-methoxyphenol, hydroquinone, 4-hydroxy-2,2,6,6-tetramethylpiperidin-1-)oxyl (4-hydroxy-TEMPO), or phenothiazene.

15. A method of making a patterned resin comprising contacting a layer comprising the polymer according to any one of claims 1-13 with a patterned template, wherein the patterned template comprises a relief structure, optionally wherein the relief structure has at least one dimension less than 100 micrometers.

## Patentansprüche

1. Ein Polymer, abgeleitet von:
(a) einem (Meth)acrylatmonomer, das eine zweite terminale Olefingruppe umfasst;
(b) einem Alkylmethacrylatmonomer, wobei die Alkylgruppe 1 bis 4 Kohlenstoffatome umfasst;
(c) einem Mono(meth)acrylatmonomer, das eine Gruppe mit niedriger Oberflächenenergie umfasst, wobei die Gruppe mit niedriger Oberflächenenergie eine perfluorierte Alkylgruppe, eine perfluorierte Polyethergruppe oder eine Silikongruppe umfasst;
(d) einem reversiblen Additions-Fragmentierungsmittel (RAFT-Mittel).

2. Das Polymer nach Anspruch 1, wobei das (Meth)acrylatmonomer, das eine zweite terminale Olefingruppe umfasst, die Formel CH₂=CQC(=O)L¹CH=CH₂ hat, wobei Q H oder CH₃ ist und L¹ eine Verbindungsgruppe mit 1 bis 9 Kohlenstoffatomen ist,
wobei optional L¹ CH₂ ist.

3. Das Polymer nach einem der vorstehenden Ansprüche, wobei das Alkylmethacrylatmonomer die Formel CH₂=C(CH₃)C(=O)OR¹ hat, wobei R¹ eine C1- bis C4-Alkylgruppe ist,
wobei optional R¹ -CH₃, -CH₂CH₃, -CH(CH₃)CH₃, -CH₂CH₂CH₃, -CH(CH₃)CH₂CH₃, -CH₂CH(CH₃)CH₃ oder -C(CH₃)₃ ist.

4. Das Polymer nach einem der vorstehenden Ansprüche, wobei ein Homopolymer des Alkylmethacrylatmonomers eine Glasübergangstemperatur hat, die über der Raumtemperatur liegt.

5. Das Polymer nach einem der vorstehenden Ansprüche, wobei das Mono(meth)acrylatmonomer mindestens eine der folgenden Formeln hat:
CH₂=CQC(=O)OL²R², wobei Q H oder CH₃ ist und L² eine Verbindungsgruppe ist, die 1 bis 9 Kohlenstoffatomen und optional eine verkettete Ethergruppe umfasst, und R² die Silikongruppe umfasst; oder
CH₂=CQC(=O)OL³R³, wobei Q H oder CH₃ ist und L³ eine Verbindungsgruppe ist, die mindestens eines von einem Ether, Ester, Amid oder Sulfonamid umfasst, und R ³ die perfluorierte Alkylgruppe oder die perfluorierte Polyethergruppe umfasst.

6. Das Polymer nach einem der Ansprüche 1 bis 5, wobei die perfluorierte Polyethergruppe Wiederholungseinheiten umfasst, die aus der Gruppe ausgewählt sind, die aus -(CpF2p)-, -(CpF2pO)-, -(CF(Q¹))-, -(CF(Q¹)O)-, -(CF(Q¹)CpF2pO)-, -(CpF2pCF(Q¹)O)- oder -(CF2CF(Q¹)O)- besteht, wobei
p eine ganze Zahl von 1 bis 10 ist; und
Q¹ ein Fluoratom, eine Perfluoralkylgruppe, eine Perfluorethergruppe, eine stickstoffhaltige Perfluoralkylgruppe, ein Perfluorpolyether oder eine Perfluoralkoxygruppe ist.

7. Das Polymer nach einem der Ansprüche 1 bis 5, wobei die Silikongruppe -[Si (CH₃)₂-O]ᵣ-Si(CH₃)₂R⁴ ist, wobei r eine ganze Zahl von 1 bis 200 ist und R⁴ eine Alkylgruppe ist, die 1 bis 8 Kohlenstoffatomen umfasst.

8. Das Polymer nach einem der vorstehenden Ansprüche, wobei das RAFT-Mittel die Formel ZC(=S)SR hat, wobei R mindestens eines von einer funktionellen Nitril- oder einer Estergruppe umfasst und Z -C₆H₅, N-(4-Pyridinyl)-N-methylamin oder -SR⁵ ist, wobei R⁵ eine Alkylgruppe mit 1-12 Kohlenstoffatomen ist.

9. Ein Polymer, umfassend: 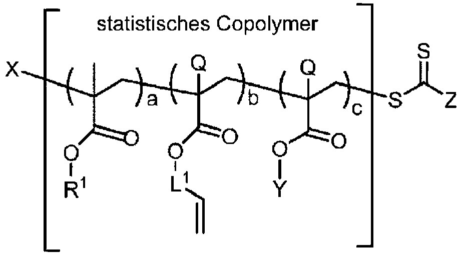 wobei:
R¹ eine Alkylgruppe ist, die 1 bis 4 Kohlenstoffatomen umfasst;
L¹ eine Verbindungsgruppe ist, die 1 bis 9 Kohlenstoffatomen umfasst, wobei optional L¹ CH₂ ist;
Y eine freisetzbare Gruppe ist, die aus -L²-R² oder -L³-R³ ausgewählt ist, wobei L² eine Verbindungsgruppe ist, die 1 bis 9 Kohlenstoffatomen und optional mindestens einem verketteten Ether umfasst, R² eine Silikongruppe umfasst, L³ eine Verbindungsgruppe ist, die mindestens eines von einem Ether, Ester, Amid oder Sulfonamid umfasst, und R³ eine perfluorierte Alkylgruppe oder eine perfluorierte Polyethergruppe umfasst;
die Q jeweils unabhängig voneinander aus H oder CH₃ ausgewählt sind;
X -C(CH₃)₂CN, -C(CH₃)₂C₆H₅, -CH(CN)C₆H₅ oder -C(CH₃)₂C(=O)OC₂H₅ umfasst;
Z -C₆H₅, -SR⁵ ist, wobei R⁵ eine Alkylgruppe ist, die 1-12 Kohlenstoffatomen oder ein einwertiges Pyrrol umfasst;
a eine ganze Zahl von 50 bis 1000 ist;
b eine ganze Zahl von 5 bis 200 ist; und
c eine ganze Zahl von 1 bis 50 ist.

10. Das Polymer nach Anspruch 9, wobei
R¹ -CH₃, -CH₂CH₃, -CH(CH₃)CH₃, -CH₂CH₂CH₃, CH(CH₃)CH₂CH₃, -CH₂CH(CH₃)CH₃ oder -C(CH₃)₃ ist.

11. Das Polymer nach Anspruch 9, wobei die perfluorierte Alkylgruppe eine lineare, verzweigte oder eine cyclische Alkylgruppe ist, die 1 bis 10 Kohlenstoffatomen umfasst.

12. Das Polymer nach Anspruch 9, wobei die perfluorierte Polyethergruppe Wiederholungseinheiten umfasst, die aus der Gruppe ausgewählt sind, die aus - (CpF2p)-, -(CpF2pO)-, -(CF(Q¹))-, -(CF(Q¹)O)-, -(CF(Q¹)CpF2pO)-, - (CpF2pCF(Q¹)O)- oder -(CF2CF(Q¹)O)- besteht,
wobei:
p eine ganze Zahl von 1 bis 10 ist; und
Q¹ ein Fluoratom, eine Perfluoralkylgruppe, eine Perfluorethergruppe, eine stickstoffhaltige Perfluoralkylgruppe, ein Perfluorpolyether oder eine Perfluoralkoxygruppe ist.

13. Das Polymer nach Anspruch 9, wobei die Silikongruppe -[Si(CH₃)₂-O]ᵣ-Si(CH₃)₂R⁴ ist, wobei r eine ganze Zahl von 1 bis 200 ist und R⁴ eine Alkylgruppe mit 1 bis 8 Kohlenstoffatomen ist.

14. Eine flüssige Zusammensetzung, umfassend
(a) ein Polymer nach einem der vorstehenden Ansprüche;
(b) ein Vernetzungsmittel, wobei das Vernetzungsmittel wahlweise ein (Meth)acrylat, ein multifunktionelles Thiol, ein (Meth)acrylamid oder Kombinationen davon umfasst;
(c) Lösungsmittel; und
(d) optional einen Photoinitiator; und
(e) optional einen Stabilisator, wobei der Stabilisator optional mindestens eines von 2,6-Di-tert-butyl-4-methylphenol (BHT), 4-Methoxyphenol, Hydrochinon, 4-Hydroxy-2,2,6,6-tetramethylpiperidin-1-)oxyl(4-hydroxy-TEMPO) oder Phenothiazen umfasst.

15. Ein Verfahren zum Herstellen eines strukturierten Kunstharzes, umfassend das Inkontaktbringen einer Schicht, die das Polymer nach einem der Ansprüche 1 bis 13 umfasst, mit einer strukturierten Vorlage, wobei die strukturierte Vorlage eine Reliefstruktur umfasst, wobei die Reliefstruktur optional mindestens eine Abmessung von weniger als 100 Mikrometern aufweist.

## Revendications

1. Polymère dérivé de :
(a) un monomère (méth)acrylate comprenant un second groupe oléfine terminal ;
(b) un monomère méthacrylate d'alkyle dans lequel le groupe alkyle comprend 1 à 4 atomes de carbone ;
(c) un monomère mono(méth)acrylate comprenant un groupe à faible énergie de surface, dans lequel le groupe à faible énergie de surface comprend un groupe alkyle perfluoré, un groupe polyéther perfluoré, ou un groupe silicone ;
(d) un agent de fragmentation par addition réversible (RAFT).

2. Polymère selon la revendication 1, dans lequel le monomère (méth)acrylate comprenant un second groupe oléfine terminal est de la formule CH₂=CQC(=O)L¹CH=CH₂, dans lequel Q est H ou CH₃ et L¹ est un groupe de liaison comprenant 1 à 9 atomes de carbone,
facultativement dans lequel L¹ est CH₂.

3. Polymère selon l'une quelconque des revendications précédentes, dans lequel le monomère méthacrylate d'alkyle est de la formule CH₂=C(CH₃)C(=O)OR¹, dans lequel R¹ est un groupe alkyle en C1 à C4,
facultativement dans lequel R¹ est -CH₃, -CH₂CH₃, -CH(CH₃)CH₃, - CH₂CH₂CH₃, CH(CH₃)CH₂CH₃, -CH₂CH(CH₃)CH₃ ou -C(CH₃)₃.

4. Polymère selon l'une quelconque des revendications précédentes, dans lequel un homopolymère du monomère méthacrylate d'alkyle a une température de transition vitreuse supérieure à la température ambiante.

5. Polymère selon l'une quelconque des revendications précédentes, dans lequel le monomère mono(méth)acrylate est d'au moins l'une des formules suivantes :
CH₂=CQC(=O)OL²R² dans lequel Q est H ou CH₃ et L² est un groupe de liaison comprenant 1 à 9 atomes de carbone et facultativement un groupe éther caténaire et R² comprend le groupe silicone ; ou
CH₂=CQC(=O)OL³R³ dans lequel Q est H ou CH₃ et L³ est un groupe de liaison comprenant au moins l'un parmi un éther, ester, amide ou sulfonamide et R³ comprend le groupe alkyle perfluoré, ou le groupe polyéther perfluoré.

6. Polymère selon l'une quelconque des revendications 1 à 5, dans lequel le groupe polyéther perfluoré comprend des motifs de répétition choisis dans le groupe de -(CpF2p)-, -(CpF2pO)-, -(CF(Q¹))-, -(CF(Q¹)O)-, -(CF(Q¹)CpF2pO)-, - (CpF2pCF(Q¹)O)- ou -(CF2CF(Q¹)O)-, dans lequel
p est un nombre entier allant de 1 à 10 ; et
Q¹ est un atome de fluor, un groupe perfluoroalkyle, un groupe perfluoroéther, un groupe perfluoroalkyle contenant de l'azote, un perfluoropolyéther ou un groupe perfluoroalcoxy.

7. Polymère selon l'une quelconque des revendications 1 à 5, dans lequel le groupe silicone est -[Si (CH₃)₂-O]ᵣ-Si(CH₃)₂R⁴ dans lequel r est un nombre entier allant de 1 à 200 et R⁴ est un groupe alkyle comprenant 1 à 8 atomes de carbone.

8. Polymère selon l'une quelconque des revendications précédentes, dans lequel l'agent RAFT est de la formule ZC(=S)SR, dans lequel R comprend au moins l'un parmi un groupe fonctionnel nitrile ou ester, et Z est -C₆H₅, N-(4-pyridinyl)-N-méthylamine ou -SR⁵ où R⁵ est un groupe alkyle comprenant 1 à 12 atomes de carbone.

9. Polymère comprenant : 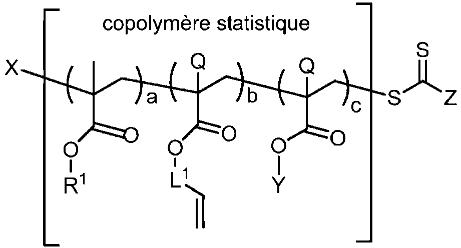 dans lequel :
R¹ est un groupe alkyle comprenant 1 à 4 atomes de carbone ;
L¹ est un groupe de liaison comprenant 1 à 9 atomes de carbone, facultativement dans lequel L¹ est CH₂ ;
Y est un groupe libérable choisi parmi -L²-R² ou -L³-R³ dans lequel L² est un groupe de liaison comprenant 1 à 9 atomes de carbone et facultativement au moins un éther caténaire, R² comprend un groupe silicone, L³ est un groupe de liaison comprenant au moins l'un parmi un éther, ester, amide ou sulfonamide, et R³ comprend un groupe alkyle perfluoré ou un groupe polyéther perfluoré ;
chaque Q est indépendamment choisi parmi H ou CH₃ ;
X comprend -C(CH₃)₂CN, -C(CH₃)₂C₆H₅, -CH(CN)C₆H₅ ou - C(CH₃)₂C(=O)OC₂H₅ ;
Z est -C₆H₅, -SR⁵ où R⁵ est un groupe alkyle comprenant 1 à 12 atomes de carbone, ou un pyrrole monovalent ;
a est un nombre entier allant de 50 à 1000 ;
b est un nombre entier allant de 5 à 200 ; et
c est un nombre entier allant de 1 à 50.

10. Polymère selon la revendication 9, dans lequel R¹ est -CH₃, -CH₂CH₃, - CH(CH₃)CH₃, -CH₂CH₂CH₃, CH(CH₃)CH₂CH₃, -CH₂CH(CH₃)CH₃ ou -C(CH₃)₃.

11. Polymère selon la revendication 9, dans lequel le groupe alkyle perfluoré est un groupe alkyle linéaire, ramifié ou cyclique comprenant 1 à 10 atomes de carbone.

12. Polymère selon la revendication 9, dans lequel le groupe polyéther perfluoré comprend des motifs de répétition choisis dans le groupe de -(CpF2p)-, - (CpF2pO)-, -(CF(Q¹))-, -(CF(Q¹)O)-, -(CF(Q¹)CpF2pO)-, -(CpF2pCF(Q¹)O)- ou - (CF2CF(Q¹)O)-,
dans lequel :
p est un nombre entier allant de 1 à 10 ; et
Q¹ est un atome de fluor, un groupe perfluoroalkyle, un groupe perfluoroéther, un groupe perfluoroalkyle contenant de l'azote, un perfluoropolyéther ou un groupe perfluoroalcoxy.

13. Polymère selon la revendication 9, dans lequel le groupe silicone est -[Si (CH₃)₂-O]ᵣ-Si(CH₃)₂R⁴ dans lequel r est un nombre entier allant de 1 à 200 et R⁴ est un groupe alkyle comprenant 1 à 8 atomes de carbone.

14. Composition liquide comprenant :
(a) un polymère selon l'une quelconque des revendications précédentes ;
(b) un agent de réticulation, facultativement dans lequel l'agent de réticulation comprend un (méth)acrylate, un thiol multifonctionnel, un (méth)acrylamide, ou des combinaisons de ceux-ci ;
(c) du solvant ; et
(d) facultativement, un photoinitiateur ; et
(e) facultativement, un stabilisant, facultativement dans lequel le stabilisant comprend au moins l'un parmi 2,6,di-tert-butyl-4-méthylphénol (BHT), 4-méthoxyphénol, hydroquinone, 4-hydroxy-2,2,6,6-tétraméthylpipéridin-1-)oxyl (4-hydroxy-TEMPO) ou phénothiazène.

15. Procédé de fabrication d'une résine à motifs comprenant la mise en contact d'une couche comprenant le polymère selon l'une quelconque des revendications 1 à 13 avec un modèle à motifs, dans lequel le modèle à motifs comprend une structure en relief, facultativement dans lequel la structure en relief a au moins une dimension inférieure à 100 micromètres.
